# EUROPEAN PATENT SPECIFICATION

(11) **EP 2 362 540 B1**
(45) Date of publication and mention of the grant of the patent: **17.04.2013**
(21) Application number: 11155336.8
(22) Date of filing: 22.02.2011
(51) Int. Cl.: H03B 5/12, H03B 5/18

(54) **Voltage-controlled microwave oscillator with improved signal/noise ratio**
Spannungsgesteuerter Mikrowellenoszillator mit verbessertem Signal-Rausch-Verhältnis
Oscillateur de commande de tension à micro-ondes avec un rapport signal sur bruit amélioré

(30) Priority: 25.02.2010 IT MI20100314
(43) Date of publication of application: 31.08.2011
(73) Proprietor: SIAE Microelettronica S.p.A., 20093 Cologno Monzese (MI) (IT)
(72) Inventor: Traversa, Antonio, 20093 Cologno Monzese (MI) (IT)
(74) Representative: Raimondi, Margherita

(56) References cited:
- US-A1- 2003 090 332

## Description

The present invention relates to a voltage-controlled microwave oscillator (VCO) with a high tuning band and improved output power/phase noise ratio at the oscillation frequency f₀.

It is known in the technical sector of electronic radiofrequency transmission circuits to provide voltage-controlled oscillators - in short "VCO" - with a so-called "push-push" structure of the active component, used in particular in oscillators manufactured using monolithic microwave integrated circuit (MMIC) technology.

In greater detail the known oscillators manufactured using said technology comprise integrated circuits which use preferably gallium arsenide (GaAs), which is known for its low dielectric losses at the microwave frequencies, as material for manufacturing the substrate, which circuits have a symmetrical structure and comprise:
- an active component with a push-push structure, which operates at half (f₀/2) the output frequency (f₀) required and is able to generate the negative differential resistance and support the oscillation and which has at its output a signal at the programmed frequency f₀;
- two LC resonant circuits, which each contain at least one variable capacitance depending on the tuning voltage and which are connected to the active component and oscillate in phase opposition at the frequency f₀/2, or half the working output frequency f₀ of the active component;
- a central node connected:
   - to the two LC resonant circuits;
   - to the circuit for adjusting the variable tuning voltage, which determines the said resonant frequency f₀/2 of the two LC circuits; and
   - to the real ground earth by means of a further LC circuit connected to ground which, resonating at the frequency f₀/2, produces a short-circuit to ground at the said frequency.

Although functional, these known VCO have the drawback, however, that they do not optimize the output power at the working frequency f₀ of the oscillator since the entire circuit is optimized to the frequency of the two half-circuits resonating at the frequency f₀/2.

A further example of known technology is disclosed in US 6,169,461 which describes a high-frequency VCO device not comprising any single resonant circuit connected to ground; the VCO is not degraded by external electromagnetic interferences and a circuit for improving the Q factor of the single resonant circuit.

US 2003/0090332 discloses a high frequency VCO with a single resonant circuit connected to ground realised through a distributed element λ/4 line resonating only at multiple values of the output frequency f₀, not able to support a wide tuning band microwave oscillator.

Apart from these, the prior art documents does not provide any indication as to how to increase the power of the output signal while maintaining the same power supply level with a consequent improvement in the signal/noise ratio.

The technical problem which is posed, therefore, is to provide an improved VCO which is able to improve the power of the signal at the output frequency f₀ of the oscillator compared to the prior art, while maintaining the same power consumption of the active circuit.

It is also required that said improvement in the output power should not simultaneously cause an increase in the phase noise of the oscillator.

In connection with this problem it is also required that the novel solution should be able to be implemented in a simple and low-cost manner using standard production techniques.

These results are achieved according to the present invention by a microwave oscillator designed according to the characteristic features of Claim 1.

Further details may be obtained from the following description of a non-limiting example of embodiment of an oscillator according to the present invention provided with reference to the accompanying drawings in which:
- Figure 1:: shows the basic diagram of a VCO according to the present invention made using MMIC technology;
- Figure 2:: shows the equivalent circuit to ground of the central node according to the present invention;
- Figure 3:: shows a perspective view of an MMIC constructional form of the circuit connected to ground according to Fig. 2;
- Figure 4:: shows a plan view of the MMIC central node connected to ground according to Fig. 3;
- Figure 5:: shows a schematic cross-section along the plane indicated by V-V in Fig. 4;
- Figure 6:: shows a graph illustrating the real part of the admittance between central node and ground of a circuit according to the prior art;
- Figure 7:: shows a graph illustrating the real part of the admittance and the real part of the impedance between central node and ground of a circuit according to the present invention;
- Figure 8a:: shows a table summarising the values, obtained during tests, of the output power (POUT) and the phase noise of an oscillator according to the prior art; and
- Figure 8b:: shows a table summarising the values, obtained during tests, of the output power (POUT) and phase noise of an oscillator according to the present invention.

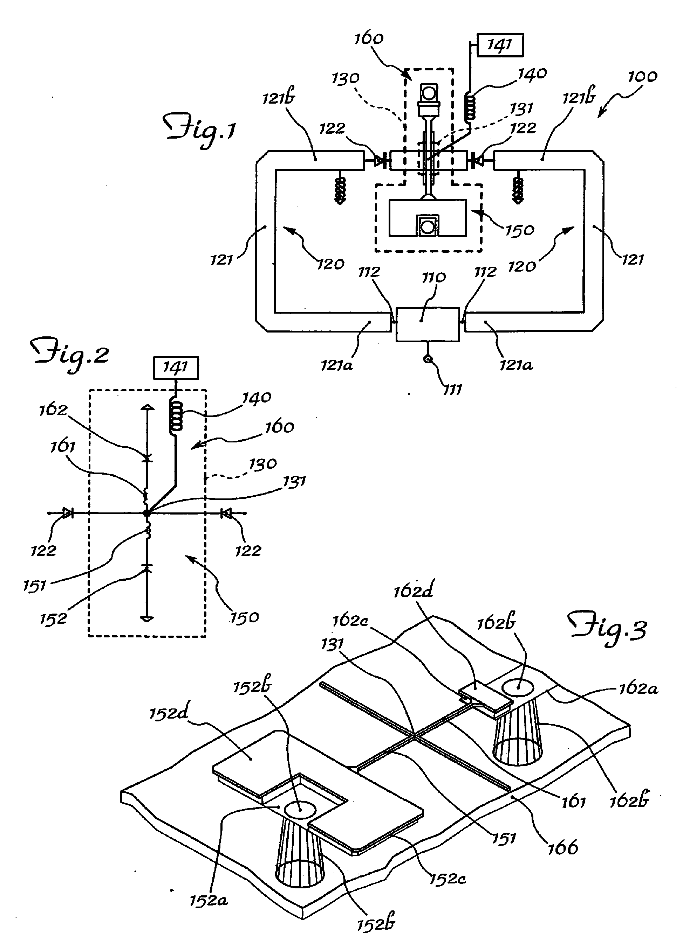

As can be seen from Fig. 1, the general diagram of a VCO 100 according to the present invention comprises:
- an active component (110) designed with a push-push structure which is conventional per se and arranged between two nodes 112, having a central output 111 of the signal at a frequency f₀ and generating a negative differential resistance at the said nodes 112 able to support oscillation at the frequency f₀/2;
- two circuits 120 resonating at a frequency f₀/2, consisting of a respective microstrip line 121 which forms the inductive part of the circuit and the opposite ends 121a,121b of which are respectively connected to the respective node 112 of the active component 110 and to a respective varactor diode 122 which forms the variable capacitive part and which allows tuning of the two circuits 120 and therefore of the oscillator 100 within the desired band;
- a central node circuit 130 comprising a central node 131 to which the following are connected:
   - the said varactor diodes 122,
   - a decoupling inductor 140 by means of which the tuning voltage 141 is applied, said tuning voltage determining the value of the equivalent capacitance of the two diodes 122 and therefore the resonant frequency f₀/2 of each circuit 120;
   - an LC circuit 150 for connecting the node 131 to the real ground of the oscillator, resonating at the frequency f₀/2 for effecting a short-circuit to ground at said frequency.

Said central node 131 forms the virtual ground for the two resonant circuits 120 which, oscillating in phase opposition, keep the voltage value constant at this point.

According to the invention the central node circuit 130 also comprises a second connection 160 between the node 131 and the ground, said second connection 160 being arranged in parallel with the first connection 150.

As shown in Fig. 2 the equivalent circuit representing the central node circuit 130 comprises:
- an inductor 151 arranged in series with a capacitor 152, which form the first connection 150 to the real ground of the oscillator;
- an inductor 161 arranged in series with a capacitor 162, which form the second connection 160 to the real ground of the node 131.

As shown in Figs. 3 to 5 a preferred embodiment of the oscillator envisages that the central node circuit 130 is made using MMIC (Microwave Monolithic Integrated Circuit) technology so as to comprise:
- a dielectric layer 166, on the opposite sides of which the following are respectively formed:
- an ground conducting layer 170,
- a capacitor 152 formed by:
   - a first plate 152a connected to the ground 170 by means of a respective metallized through-hole 152b,
   - a dielectric layer 152c and
   - a second plate 152d which is connected to the node 131 by means of the inductor 151 made using microstrip technology,
      which form the first connection 150 of the node 131 to ground;
- a capacitor 162 formed by:
   - a first plate 162a connected to the ground 170 by means of a respective metallized through-hole 162b,
   - a dielectric layer 162c and
   - a second plate 162d which is connected to the node 131 by means of the inductor 161 made using microstrip technology,
   which form the second connection of the node 131 to ground in parallel with the first connection.

According to the invention it is envisaged that the values of the capacitance of the capacitor 162 and the inductor 161, in combination with the capacitor 152 and the inductor 151, are such as produce in the node 131 a very low impedance circuit which is as similar as possible to a short-circuit, at the frequency f₀/2 and at the same time a very high impedance circuit which is close as possible to an open circuit, at the frequency f₀.

At this frequency (f₀) the node 131 is not situated on a stationary oscillating node (as at the frequency f₀/2) and therefore must have a high impedance to ground in order not to attenuate the transfer of power to the output 111.

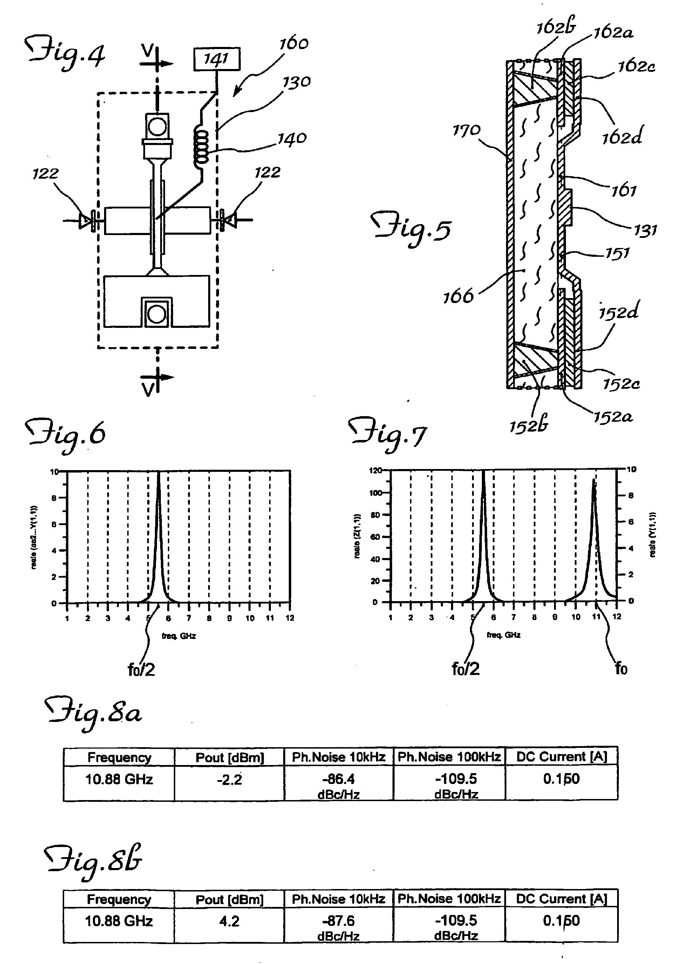

As shown in the graphs of Figs. 6 and 7 which respectively show the real part of the admittance (Y (1,1)) and the real part of the impedance (Z (1,1)) between central node 131 and ground of a central node circuit 130 according to the prior art and according to th present invention, the oscillator according to the present invention has both a peak (short circuit) in the real part of the admittance (**left side Y axis**) at the frequency f₀/2 and a peak (open circuit) in the real part of the impedance ((**right side Y axis**) at the frequency f₀, which is not present in the graph of the circuit of the known oscillator in which only the peak of the admittance at the frequency f₀/2 can be seen.

By imposing the open circuit condition on the node 131 at the frequency f₀ the useful signal is prevented from being dissipated at the node 131, as occurs in oscillators designed according to the prior art.

The tables shown in Figs. 8 and 8b show the results of tests carried out in order to compare the values of the output power (POUT) and the phase noise of an oscillator designed according to the prior art (Fig. 4a) with those of an oscillator designed according to the present invention (Fig. 4a). Having defined for both oscillators the same working frequency f₀ and a same active circuit of the push-push type both with the same power consumption (150mA), from the values recorded it can be noted how the oscillator designed according to the present invention provides an output power which is 6dB higher than that of the oscillator according to the prior art.

In addition, the recorded values show how the phase noise is improved by about 1 dB at the offset frequency of 10 kHz and remains substantially constant at the other frequencies.

It is therefore clear how the voltage-controlled microwave oscillator (VCO) with wide tuning band, having an active component with push-push structure as designed according to the present invention, is able to provide, for the same power consumption of the active circuit, a gain in output power greater than that which is obtained with oscillators designed using the known technology, while keeping the phase noise substantially unchanged.

In addition, implementation of the oscillator according to the present invention involves low production costs and does not require the use of construction technology different from that used to manufacture the (MMIC) oscillators according to the prior art.

Although described in connection with certain constructional forms and certain preferred examples of embodiment of the invention, it is understood that the scope of protection of the present patent is defined solely by the following claims.

## Claims

1. Voltage-controlled microwave oscillator (100) comprising:
- an active component (110) designed with a push-push structure and arranged between two nodes (112), with a central output (111) at a frequency f₀ and having a negative differential resistance at the said nodes (112) able to support an oscillation at the frequency f₀/2;
- two circuits (120) resonating at a frequency f₀/2, consisting of a respective microstrip line 121 which forms the inductive part of the circuit, the opposite ends (121a,121b) of which are respectively connected to the associated node (112) of the active component (110) and to a respective varactor diode (122);
- a central node circuit (130) comprising a central node (131) to which the following are connected:
. the said varactor diodes (122) of the two resonating circuits (120),
. a decoupling inductor (140);
. a first LC circuit (150) connected to ground comprising a first inductor (151) and a first capacitor (152) connecting the central node (131) to the real ground of the oscillator and resonating at the frequency f₀/2 so as to produce a short-circuit to ground at said frequency,
**characterized in that**
it comprises a second LC circuit (160) connected to ground for connecting the central node (131) to ground, arranged in parallel with the first circuit (150), comprising a second capacitor (162) and a second inductor (161) arranged in series,
said first LC circuit (150) and second LC circuit (160) being of the lumped elements type and able to produce a short-circuit at the frequency f₀/2 and an open circuit at the output frequency f₀.

2. Device according to Claim 1, **characterized in that** said oscillator is made using monolithic microwave integrated circuit, MMIC technology.

3. Device according to Claim 2, **characterized in that** it comprises a dielectric layer (166), on the opposite sides of which the following are respectively formed:
- an ground conductive layer (170);
- a first capacitor (152) and a second capacitor (162) which are respectively formed by a first plate (152a,162a) connected to the ground (170), a dielectric layer (152c,162c) and a second plate (152d,162d) connected to the central node (131) by means of a respective inductor (151,161) in series, which realize the central node circuit (130) comprising the first circuit (150) and the second circuit (160) connecting the central node (131) to ground.

4. Device according to Claim 3, **characterized in that** said ground connection of the central node (131) via the two connection circuits (150,160) in parallel is realized by means of metallized holes (152b,162b) passing through the dielectric substrate and electrically connected to the first plate (152a,162a) of the respective first capacitor (152) and second capacitor (162).

5. Device according to Claim 3, **characterized in that** said inductors (151,161) of the respective circuits (150,160) for connecting the central node (131) to ground are made using microstrip technology.

6. Device according to Claim 3, **characterized in that** the dielectric substrate is made of gallium arsenide, GaAs.

## Patentansprüche

1. Spannungsgesteuerter Mikrowellenoszillator (100) umfassend:
- eine aktive Komponente (110), die mit einer Push-Push-Struktur ausgebildet und zwischen zwei Knoten (112) angeordnet ist, und eine zentrale Ausgabe (111) bei einer Frequenz f₀ sowie einen negativen differenziellen Widerstand an den Knoten (112) aufweist und in der Lage ist, bei der Frequenz f₀/2 eine Oszillation zu unterstützen;
- zwei Schaltkreise (120), die bei einer Frequenz f₀/2 in Resonanz treten und aus einer entsprechenden Mikrostreifenleitung (121) bestehen, die den induktiven Teil des Schaltkreises bildet, wobei die gegenüberliegenden Enden (121 a, 121 b) davon jeweils mit dem dazugehörigen Knoten (112) der aktiven Komponente (110) und mit einer entsprechenden Varaktordiode (122) verbunden sind;
- einen Schaltkreis mit zentralem Knoten (130), der einen zentralen Knoten (131) umfasst, mit dem Folgendes verbunden ist:
- die Varaktordioden (122) der zwei Schwingkreise (120);
- ein Entkopplungsinduktor (140);
- ein erster mit Masse verbundener LC-Schaltkreis (150), der einen ersten Induktor (151) und einen ersten Kondensator (152) umfasst, die den zentralen Knoten (131) mit der realen Masse des Oszillators verbinden und bei der Frequenz f₀/2 in Resonanz treten, um bei dieser Frequenz einen Kurzschluss gegen Masse herzustellen,
**dadurch gekennzeichnet, dass**:
der Mikrowellenoszillator einen zweiten mit Masse verbundenen LC-Schaltkreis (160) umfasst, um den zentralen Knoten (131) mit Masse zu verbinden, welcher parallel zum ersten Schaltkreis (150) angeordnet ist und einen zweiten Kondensator (162) und einen zweiten Induktor (161) umfasst, die in Serie geschaltet sind,
wobei der erste LC-Schaltkreis (150) und der zweite LC-Schaltkreis (160) aus konzentrierten Elementen bestehen und in der Lage sind, bei der Frequenz f₀/2 einen Kurzschluss und bei der Ausgabefrequenz f₀ einen Leerlauf herzustellen.

2. Vorrichtung nach Anspruch 1, **dadurch gekennzeichnet, dass** der Oszillator mithilfe der monolithischen, integrierten Mikrowellenschaltkreistechnik, MMIC, hergestellt ist.

3. Vorrichtung nach Anspruch 2, **dadurch gekennzeichnet, dass** sie eine dielektrische Schicht (166) umfasst, auf deren gegenüberliegenden Seiten jeweils Folgendes ausgebildet ist:
- eine Masseleitungsschicht (170);
- ein erster Kondensator (152) und ein zweiter Kondensator (162), die jeweils durch eine mit Masse (170) verbundene erste Platte (152a, 162a), eine dielektrische Schicht (152c, 162c) und eine zweite Platte (152d, 162d) gebildet werden, die mithilfe eines entsprechenden Induktors (151, 161) mit dem zentralen Knoten (131) in Serie geschaltet sind, wodurch die Schaltung mit zentralem Knoten realisiert wird, welche den ersten Schaltkreis (150) und den zweiten Schaltkreis (160) umfasst, die den zentralen Knoten (131) mit Masse verbinden.

4. Vorrichtung nach Anspruch 3, **dadurch gekennzeichnet, dass** die Masseverbindung des zentralen Knotens (131) über die zwei parallelen Verbindungsschaltungen (150, 160) mithilfe metallisierter Löcher (152b, 162b) realisiert ist, welche durch das dielektrische Substrat durchgehen und elektrisch mit der ersten Platte (152a, 162a) des entsprechenden ersten Kondensators (152) und zweiten Kondensators (162) verbunden sind.

5. Vorrichtung nach Anspruch 3, **dadurch gekennzeichnet, dass** die Induktoren (151, 161) der jeweiligen Schaltkreise (150, 160) zum Verbinden des zentralen Knotens (131) mit Masse mithilfe der Mikrostreifentechnik hergestellt sind.

6. Vorrichtung nach Anspruch 3, **dadurch gekennzeichnet, dass** das dielektrische Substrat aus Galliumarsenid, GaAs, hergestellt ist.

## Revendications

1. Oscillateur à micro-ondes commandé en tension (100), comprenant :
- un composant actif (110) conçu avec une structure asymétrique et disposé entre deux noeuds (112), avec une sortie centrale (111) à une fréquence f₀ et comportant une résistance différentielle négative au niveau desdits noeuds (112) capable de supporter une oscillation à la fréquence f₀/2 ;
- deux circuits (120) résonant à une fréquence f₀/2, constitués d'une ligne micro-ruban respective (121) qui forme la partie inductive du circuit, les extrémités opposées (121 a, 121b) duquel sont connectées, respectivement, au noeud associé (112) du composant actif (110) et à une diode à capacité variable associée (122);
- un circuit à noeud central (130) comprenant un noeud central (131) auquel est connecté ce qui suit :
. lesdites diodes à capacité variable (122) des deux circuits résonants (120) ;
. un inducteur de découplage (140) ;
. un premier circuit LC (150) connecté à la terre comportant un premier inducteur (151) et un premier condensateur (152) connectant le noeud central (131) à la terre active de l'oscillateur et résonant à la fréquence f₀/2 de façon à produire un court-circuit à la terre au niveau de ladite fréquence,
**caractérisé en ce que** :
il comporte un second circuit LC (160) connecté à la terre pour connecter le noeud central (131) à la terre, disposé en parallèle au premier circuit (150),
comprenant un second condensateur (162) et un second inducteur (161) disposés en série,
ledit premier circuit LC (150) et ledit second circuit LC (160) étant du type à éléments groupés et pouvant produire un court-circuit à la fréquence f₀/2 et un circuit ouvert à la fréquence de sortie f₀.

2. Dispositif selon la revendication 1, **caractérisé en ce que** ledit oscillateur est fabriqué en utilisant une technologie de circuit intégré monolithe pour micro-ondes.

3. Dispositif selon la revendication 2, **caractérisé en ce qu'**il comporte une couche diélectrique (166), sur les côtés opposés desquelles ce qui suit est, respectivement, formé :
- une couche conductrice de terre (170) ;
- un premier condensateur (152) et un second condensateur (162) qui sont formés, respectivement, par une première plaque (152a, 162a) connectée à la terre (170), une couche diélectrique (152c, 162c) et une seconde plaque (152d, 162d) connectée en série au noeud central (131) au moyen d'un inducteur respectif (151, 161), lesquels constituent le circuit à noeud central (130) comportant le premier circuit (150) et le second circuit (160) connectant le noeud central (131) à la terre.

4. Dispositif selon la revendication 3, **caractérisé en ce que** ladite connexion à la terre du noeud central (131) par l'intermédiaire des deux circuits de connexion (150, 160) en parallèle est obtenue au moyen de trous métallisés (152b, 162b) traversant le substrat diélectrique et connectés électriquement à la première plaque (152a, 162a) des premier (152) et second (162) condensateurs respectifs.

5. Dispositif selon la revendication 3, **caractérisé en ce que** lesdits inducteurs (151, 161) des circuits respectifs (150, 160) permettant de connecter le noeud central (131) à la terre sont fabriqués en utilisant la technologie à micro-ruban.

6. Dispositif selon la revendication 3, **caractérisé en ce que** le substrat diélectrique est constitué d'arséniure de gallium GaAs.
